# EUROPEAN PATENT SPECIFICATION

(11) **EP 4 071 830 B1**
(45) Date of publication and mention of the grant of the patent: **04.11.2026**
(21) Application number: 21908075.1
(22) Date of filing: 21.12.2021
(51) Int. Cl.: H10F 10/166, H10F 71/00, H10F 77/20, H10F 77/30

(54) **HIGH-EFFICIENCY SILICON HETEROJUNCTION SOLAR CELL AND PREPARATION METHOD THEREFOR**
HOCHEFFIZIENTE SILIZIUM-SOLARZELLE MIT HETEROÜBERGANG UND HERSTELLUNGSVERFAHREN DAFÜR
CELLULE SOLAIRE À HÉTÉROJONCTION DE SILICIUM À HAUT RENDEMENT ET SON PROCÉDÉ DE PRÉPARATION

(30) Priority: 09.02.2021 CN 202110175285
(43) Date of publication of application: 12.10.2022
(73) Proprietor: Tongwei Solar (Jintang) Co., Ltd., Chengdu City Sichuan 610400 (CN)
(72) Inventor: WANG, Jinle, Chengdu Sichuan 610299 (CN)
(74) Representative: Marks & Clerk LLP
(86) International application number: PCT/CN2021/139981
(87) International publication number: WO 2022/170860

(56) References cited:
- CN-A- 102 460 715
- CN-A- 108 701 736
- CN-A- 109 119 491
- CN-A- 109 509 807
- CN-A- 111 697 110
- CN-A- 112 151 636
- CN-A- 112 802 910
- CN-U- 208 806 263
- CN-U- 215 220 730
- US-A1- 2017 222 074
- DING KAINING ET AL: "Mechanism for crystalline Si surface passivation by the combination of SiO 2 tunnel oxide and c-SiC:H thin film", PHYSICA STATUS SOLIDI. RAPID RESEARCH LETTERS, vol. 10, no. 3, 14 December 2015 (2015-12-14), DE, pages 233 - 236, XP055893383, ISSN: 1862-6254, DOI: 10.1002/pssr.201510376

## Description

### TECHNICAL FIELD

The present application relates to the technical field of solar cells, and in particular, to a high-efficiency silicon heterojunction (HJT) solar cell and a manufacturing method thereof.

### BACKGROUND

At present, mainstream cell products in the market are P-type monocrystalline PERC cells, but efficiency of the P-type monocrystalline PERC cells has reached an upper limit. However, with the continuous development of market demands and industry technologies, a technology of N-type crystalline silicon solar cells has received more and more attention in recent years, mainly including a passivated emitter rear totally diffused (n-PERT) cell, a tunnel oxide passivated contact (TOPCon) cell and an HJT cell. The N-type crystalline silicon solar cells enable a further breakthrough in the conversion efficiency of the crystalline silicon solar cells.

An existing HJT cell has a structure consisting of an intrinsic layer and a doped layer of amorphous silicon on two surfaces of N-type monocrystalline silicon. The intrinsic layer of amorphous silicon mainly passivates defects on a surface of crystalline silicon and reduces defect states on the surface, so as to reduce carrier recombination. The doped layer of amorphous silicon mainly forms a PIN junction and a field-effect passivation layer with the crystalline silicon. SiO₂ has excellent surface passivation performance and can effectively reduce interfacial state density, but SiO₂ has a wider energy gap than the amorphous silicon.

A silicon HJT cell is a solar cell in which an intrinsic hydrogenated amorphous silicon layer is added between an N-type amorphous silicon layer and a crystalline silicon substrate. The intrinsic amorphous silicon layer is configured to passivate a doped silicon substrate. However, an intrinsic amorphous silicon layer deposited on the crystalline silicon substrate produces microscopic defects due to the doping of a hydrogen element and H plasma bombardment, resulting in epitaxial growth during the formation of hydrogenated amorphous silicon, which affects a passivation effect and results in a low open-circuit voltage. Moreover, an epitaxial layer formed on the side of the silicon substrate towards a P-type amorphous silicon layer is within a built-in electric field, the epitaxial layer has great influence on a silicon HJT solar cell.

A main method to inhibit epitaxial growth of the hydrogenated amorphous silicon on the surface of crystalline silicon is that the amorphous silicon layer near the outermost surface of crystalline silicon is not doped with H. That is, the intrinsic amorphous silicon thin layer is in direct contact with a silicon substrate. In addition, an ultrathin intrinsic silicon oxide layer may be deposited at an interface of the crystalline silicon substrate on one side of the P-type amorphous silicon layer, and then an intrinsic silicon layer is deposited. Oxygen doping in the intrinsic silicon oxide layer is used to inhibit epitaxial growth of an intrinsic amorphous silicon film and reduce the number of defects at the interface, so as to achieve a better passivation effect. However, diffusion of doped atoms in the doped layer towards the intrinsic layer also affects the passivation effect.

On the other hand, in the related art, an amorphous silicon layer that is doped P-type is completed by doping of B₂H₆. The amorphous silicon layer that is doped P-type formed by doping of B₂H₆ has poor thermal stability, and B atoms easily diffuse into the intrinsic layer of amorphous silicon, which affects the passivation effect of the intrinsic layer and leads to a low open-circuit voltage and low conversion efficiency of the solar cell. In addition, the amorphous silicon doped layer formed by doping of B₂H₆ has a low energy gap. As a result, more sunlight is absorbed, and optical losses are increased, leading to a low short-circuit current and low conversion efficiency of the solar cell.

Upon searching, in the Chinese patent CN109509807A, entitled "emitter structure of crystalline silicon heterojunction solar cell and manufacturing method thereof", an N-type crystal silicon wafer is included, the N-type crystal silicon wafer is provided with an amorphous silicon intrinsic layer on each of front and rear surfaces, a TCO conductive film is arranged on an outer side of each of the amorphous silicon intrinsic layers, several Ag electrodes are arranged an outer side of each of the TCO conductive films, an amorphous silicon layer that is doped N-type is arranged between the amorphous silicon intrinsic layer and the TCO conductive film on one surface of the N-type crystal silicon wafer, and a TMB-doped layer and a B₂H₆-doped layer are arranged between the amorphous silicon intrinsic layer and the TCO conductive film on the other surface of the N-type crystal silicon wafer. In that application, the doping by using TMB gas prevents diffusion of doped atoms B into the amorphous silicon intrinsic layer and increases the open-circuit voltage. The TMB gas has a large energy gap, so that light can more effectively pass through the doped layer, increasing the short-circuit current. B₂H₆ gas is used for doping on the side close to TCO, so that the conductivity of the doped layer is better. Photoelectric conversion efficiency of the HJT solar cell is improved. In that application, although the lightly boron doped layer is used to get close to the amorphous silicon intrinsic layer, part of B atoms may still diffuse into the amorphous silicon intrinsic layer, which may affect the film quality of the amorphous silicon intrinsic layer and reduce the open-circuit voltage to some extent.

DING KAINING ET AL: "Mechanism for crystalline Si surface passivation by the combination of SiO2 tunnel oxide and µc-SiC:H thin film" PHYSICA STATUS SOLIDI, RAPID RESEARCH LETTERS, vol. 10, no. 3, 14 December 2015, p. 233-236 demonstrates that the combination of a wet-chemically grown SiO₂ tunnel oxide with a highly-doped microcrystalline silicon carbide layer grown by hot-wire chemical vapor deposition yields an excellent surface passivation for c-Si wafers as indicated by the highest achieved effective carrier lifetimes of well above 6 ms.

CN208806263U discloses a passivation contact electrode structure and a solar cell applicable thereto. The electrode structure comprises a doped semiconductor layer deposited on a crystalline silicon substrate and a copper electrode on the doped semiconductor layer; the doped semiconductor layer is any one of polycrystalline silicon, microcrystalline silicon or microcrystalline silicon carbon alloy, and has a thickness of 5-100 nm.

CN111697110A provides a heterojunction solar cell and a manufacturing method thereof. The heterojunction solar cell comprises an N-type silicon wafer having a first surface and a second surface, the heterojunction solar cell further comprises a first intrinsic amorphous silicon layer, an N-type amorphous silicon layer, a first transparent conductive film and a first electrode stacked sequentially on the first surface, and a second intrinsic amorphous silicon layer, a P-type amorphous silicon layer, a second transparent conductive film and a second electrode stacked sequentially on the second surface, and a first silicon oxide layer is arranged between any one of the first intrinsic amorphous silicon layer and the second intrinsic amorphous silicon layer and the silicon wafer.

CN112151636A discloses a silicon-based heterojunction solar cell and a manufacturing method thereof, wherein the silicon-based heterojunction solar cell comprises a substrate, a passivation layer, an electron transport layer and a transparent conductive oxide layer which are stacked in sequence, wherein the electron transport layer is a nano-silicon oxide layer, an intrinsic nano-silicon layer is arranged between the nano-silicon oxide layer and the passivation layer, and/or an n-type doped amorphous silicon layer is arranged between the nano-silicon oxide layer and the transparent conductive oxide layer.

CN109119491A discloses a solar cell structure and a manufacturing method thereof. The structure includes a silicon substrate, a first passivation structure and a second passivation structure. The silicon substrate has a first surface and a second surface which are opposite to each other; the first passivation structure covers the first surface of the silicon substrate, and includes a first amorphous silicon dioxide passivation layer and a first intrinsic amorphous silicon passivation layer which are sequentially stacked on the first surface; and the second passivation structure covers the second surface of the silicon substrate, and includes a second amorphous silicon dioxide passivation layer and a second intrinsic amorphous silicon passivation layer which are sequentially stacked on the second surface.

### SUMMARY

In order to overcome the shortcomings of the related art, the present application provides a high-efficiency silicon HJT solar cell and a manufacturing method thereof. In the present application, the hydrogenated amorphous carbon silicon oxide film layer is used as an HJT solar cell of an intrinsic passivation layer, which can achieve an excellent passivation effect on a crystal silicon surface and reduce interfacial carrier recombination. At the same time, an improved double diffused B process is used to prevent a decrease in an energy gap and unnecessary passivation film doping caused by diffusion of B atoms into an intrinsic amorphous silicon layer during B₂H₆ doping, which improves conversion efficiency of the silicon HJT solar cell.

In order to achieve the above objective, the present application provides the following technical solution.

The invention is set out in the appended set of claims.

The present application provides a high-efficiency silicon HJT solar cell, including an N-type crystal silicon wafer, a thin SiO₂ layer, a hydrogenated amorphous carbon silicon oxide film layer, a carbon doped SiO₂ layer, an amorphous silicon layer that is doped N-type, a TCO conductive layer, and an electrode being sequentially arranged at a front side of the N-type crystal silicon wafer; and a thin SiO₂ layer, a hydrogenated amorphous carbon silicon oxide film layer, a carbon doped SiO₂ layer, an amorphous silicon layer that is doped P-type, a TCO conductive layer, and an electrode being sequentially arranged at a rear side of the N-type crystal silicon wafer.

Further, the thin SiO₂ layer has a thickness in a range from 1 nm to 3 nm, and passivates a surface of a silicon substrate.

Further, the hydrogenated amorphous carbon silicon oxide film layer has a thickness in a range from 2 nm to 10 nm and an energy gap in a range from 1.7 eV to 2.3 eV

Further, the hydrogenated amorphous carbon silicon oxide film layer is non-stoichiometric and has a chemical formula expressed as a-SiOxCy:H, with a non-stoichiometric ratio x changing in a range from 0.05 to 0.95 and a non-stoichiometric ratio y changing in a range from 0.05 to 0.95.

Further, the carbon doped SiO₂ layer has a thickness in a range from 1 nm to 5 nm, and a small number of lightly boron doped or lightly phosphorus doped atoms are contained in a manner of doping the SiO₂ layer with the same family, so as to prevent the influence on the passivation effect due to unnecessary doping of the intrinsic hydrogenated amorphous carbon silicon oxide film (a-SiOxCy:H) layer.

Further, the amorphous silicon layer that is doped P-type has a thickness in a range from 10 nm to 30 nm; the amorphous silicon layer that is doped P-type includes a lightly boron doped amorphous silicon layer and a heavily boron doped amorphous silicon layer, the lightly boron doped amorphous silicon layer is close to the carbon doped SiO₂ layer, and the heavily boron doped amorphous silicon layer is close to the TCO conductive layer.

Further, the lightly boron doped amorphous silicon layer is formed by TMB gas doping, and has a thickness in a range from 2 nm to 20 nm and an energy gap in a range from 1.7 eV to 1.8 eV.

Further, the heavily boron doped amorphous silicon layer is formed by B₂H₆ gas doping, and has a thickness in a range from 2 nm to 20 nm and an energy gap in a range from 1.4 eV to 1.6 eV.

Further, the amorphous silicon layer that is doped N-type has a thickness in a range from 10 nm to 30 nm; the amorphous silicon layer that is doped N-type includes a lightly phosphorus doped amorphous silicon layer and a heavily phosphorus doped amorphous silicon layer, the lightly phosphorus doped amorphous silicon layer is close to the carbon doped SiO₂ layer, and the heavily phosphorus doped amorphous silicon layer is close to the TCO conductive layer; the lightly phosphorus doped amorphous silicon layer has a thickness in a range from 2 nm to 20 nm, and the heavily phosphorus doped amorphous silicon layer has a thickness in a range from 2 nm to 20 nm. The heavily phosphorus doped amorphous silicon layer may be formed by plasma chemical vapor deposition, or formed by laser heating and curing by coating the lightly phosphorus doped amorphous silicon layer with a liquid phosphorus source.

The present application provides a manufacturing method for a high-efficiency silicon HJT solar cell, including the following steps:
texturing and cleaning the N-type crystal silicon wafer;
forming thin SiO₂ layers on two surfaces of the N-type crystal silicon wafer by thermal oxidation;
growing, by plasma enhanced chemical vapor deposition (PECVD), a hydrogenated amorphous carbon silicon oxide film layer on each of a front surface and a rear surface of the N-type crystal silicon wafer on which the thin SiO₂ layers are formed;
forming a carbon doped SiO₂ layer by PECVD, wherein a C source is CO;
forming an amorphous silicon layer that is doped N-type and an amorphous silicon layer that is doped P-type by PECVD; the amorphous silicon layer that is doped N-type including a lightly phosphorus doped amorphous silicon layer (i.e., an N-type amorphous silicon layer lightly doped with P atoms) and a heavily phosphorus doped amorphous silicon layer (i.e., an N-type amorphous silicon layer heavily doped with P atoms), and the amorphous silicon layer that is doped P-type including a P-type amorphous silicon layer lightly doped with B atoms formed by TMB gas doping and a P-type amorphous silicon layer heavily doped with B atoms formed by B₂H₆ gas doping;
depositing a TCO conductive layer by reactive ion deposition or sputtering; and
forming front and rear Ag electrodes by screen printing, and curing the front and rear Ag electrodes, so as to form good ohmic contact with the TCO conductive film.

Further, the growing, by PECVD, a hydrogenated amorphous carbon silicon oxide film layer on each of a front surface and a rear surface of the N-type crystal silicon wafer (1) on which the thin SiO₂ layers are formed includes: vacuuming to below 5×10⁻⁴ Pa, taking H₂ and SiH₄ as reaction gases and CO as a carbon source, and providing an oxygen source to grow the hydrogenated amorphous carbon silicon oxide film layer under conditions that the N-type crystal silicon wafer is at a temperature in a range from 150°C to 300°C and deposition pressure is in a range from 10 Pa to 100 Pa, wherein a percentage of a volume of carbon monoxide in a sum of volumes of carbon monoxide and SiH₄ is between 5% and 30%.

Further, the forming an amorphous silicon layer that is doped N-type and an amorphous silicon layer that is doped P-type by PECVD includes: after base vacuum of a vacuum chamber reaches 5×10⁻⁴ Pa, growing the amorphous silicon layer that is doped N-type and the amorphous silicon layer that is doped P-type on the hydrogenated amorphous carbon silicon oxide film layer on the rear surface at a temperature of a silicon wafer substrate in a range from 100°C to 300°C by taking H₂, SiH₄, doped TMB, B₂H₆, and PH₃ as reaction gases, and deposition pressure in a range from 10 Pa to 300 Pa.

Further, the depositing a TCO conductive layer by reactive ion deposition or sputtering includes: depositing a transparent conductive ITO film at each of the front and rear sides by magnetron sputtering, the film having a thickness in a range from 70 nm to 110 nm, transmittance above 98%, and sheet resistance in a range from 50 Ω/□ to 100 Ω/□.

Further, the forming front and rear electrodes by screen printing includes: printing another layer of low-temperature conductive silver paste on the TCO conductive layers at the front and rear sides by screen printing, and then sintering the low-temperature conductive silver paste at a low temperature in a range from 150°C to 300°C to form good ohmic contact; an Ag electrode having a thickness in a range from 5 µm to 50 µm, a width in a range from 20 µm to 60 µm, and a spacing in a range from 1 mm to 5 mm.

The technical solution according to the present application has the following significant effects compared with existing conventional arts.
(1) In the high-efficiency silicon HJT solar cell of the present application, a surface of a silicon substrate is passivated by a high-quality thin SiO₂ layer to passivate broken bonds on the surface of crystalline silicon, and an intrinsic hydrogenated amorphous carbon silicon oxide film (a-SiOxCy:H) layer can modulate an energy gap to provide excellent passivation performance and provide a hydrogen passivation interface.
(2) In the high-efficiency silicon HJT solar cell of the present application, a small number of lightly boron doped or lightly phosphorus doped atoms diffusing into the intrinsic hydrogenated amorphous carbon silicon oxide film (a-SiOxCy:H) layer are contained in a manner of doping the SiO₂ layer with the same family, so as to prevent unnecessary doping of the intrinsic hydrogenated amorphous carbon silicon oxide film (a-SiOxCy:H) layer and ensure the passivation effect.
(3) In the high-efficiency silicon HJT solar cell of the present application, P-type and N-type heavily doped amorphous silicon layers can form good electrical contact with the TCO layer. The amorphous silicon layer that is doped P-type on a backlight surface is of a dual stacked structure, and TMB gas is used for doping near the carbon doped SiO₂ layer to prevent the diffusion of the doped atoms B (boron) into the intrinsic layer of amorphous silicon, so as to ensure a passivation effect of intrinsic amorphous silicon and increase an open-circuit voltage Voc. The doped amorphous silicon layer close to crystalline silicon is doped with TMB gas, and has a large energy gap, so the light can pass through the doped layer in a higher proportion, thereby increasing absorption of the light by crystalline silicon and increasing a short-circuit current Isc. The doped amorphous silicon layer close to one side of the TCO is heavily doped with B₂H₆ gas. The conductivity of the doped layer is better, and series resistance Rs of the solar cell is lower, so that a filling factor (FF) is higher. Finally, the photoelectric conversion efficiency of the HJT solar cell is improved.

### BRIEF DESCRIPTION OF THE DRAWINGS

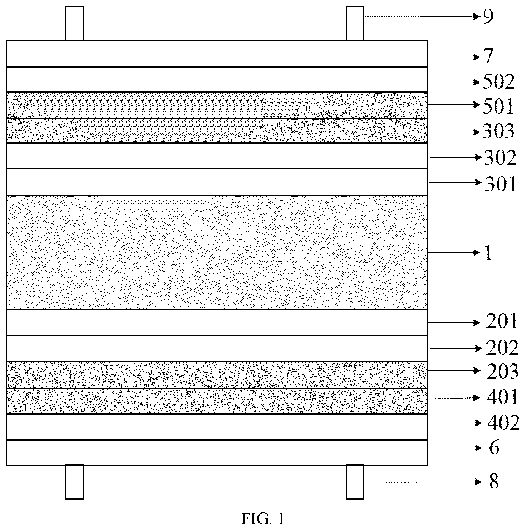

FIG. 1 is a structural diagram of a high-efficiency silicon HJT solar cell according to the present application.
1: N-type crystal silicon wafer; 201 (301): thin SiO₂ layer; 202 (302): hydrogenated amorphous carbon silicon oxide film layer; 203 (303): carbon doped SiO₂ layer; 401: lightly boron doped amorphous silicon layer; 402: heavily boron doped amorphous silicon layer; 501: lightly phosphorus doped amorphous silicon layer; 502: heavily phosphorus doped amorphous silicon layer; 6 (7): TCO conductive layer; 8 (9): electrode.

### DETAILED DESCRIPTION OF THE EMBODIMENTS

In order to further understand the content of the present application, the present application is described in detail with reference to the accompanying drawings and embodiments.

### Embodiment 1

Referring to FIG. 1, a high-efficiency silicon HJT solar cell in this embodiment includes an N-type crystal silicon wafer 1. A thin SiO₂ layer 301, a hydrogenated amorphous carbon silicon oxide film layer 302, a carbon doped SiO₂ layer 303, an amorphous silicon layer that is doped N-type, a TCO conductive layer 7, and an electrode 9 are sequentially arranged at a front side of the N-type crystal silicon wafer 1. A thin SiO₂ layer 201, a hydrogenated amorphous carbon silicon oxide film layer 202, a carbon doped SiO₂ layer 203, an amorphous silicon layer that is doped P-type, a TCO conductive layer 6, and an electrode 8 are sequentially arranged at a rear side of the N-type crystal silicon wafer 1.

The high-quality thin SiO₂ layer has a thickness of 1 nm, and passivates a surface of a silicon substrate.

The hydrogenated amorphous carbon silicon oxide film layer has a thickness of 2 nm. In this embodiment, the hydrogenated amorphous carbon silicon oxide film layer is non-stoichiometric and has a chemical formula expressed as a-SiOxCy:H, with a non-stoichiometric ratio x changing in a range from 0.05 to 0.95 and a non-stoichiometric ratio y changing in a range from 0.05 to 0.95. By changing the non-stoichiometric ratios x and y, the energy gap may be adjusted in a range from 1.7 eV to 2.3 eV.

Silicon carbide is an important anti-reflection layer and a passivation layer of a crystalline silicon cell. In combination with advantages of silicon oxide, silicon carbide, and intrinsic amorphous silicon, the hydrogenated amorphous carbon silicon oxide film (a-SiOxCy:H) layer can be obtained by adjusting the composition. By changing the non-stoichiometric ratios x and y, the performance of the hydrogenated amorphous carbon silicon oxide film layer, such as optical energy gap, can be adjusted to achieve excellent passivation performance and a thick film thickness.

In this embodiment, the hydrogenated amorphous carbon silicon oxide film layer has a non-stoichiometric ratio x of 0.05 and a non-stoichiometric ratio y of 0.95, and the energy gap may be modulated to 2.3 eV

The carbon doped SiO₂ layer has a thickness of 1 nm.

The amorphous silicon layer that is doped P-type has a thickness of 10 nm, and the amorphous silicon layer that is doped N-type has a thickness of 10 nm. The TCO conductive layer has a thickness of 70 nm.

In this embodiment, a surface of a silicon substrate is passivated by a high-quality thin SiO₂ layer to passivate broken bonds on the surface of crystalline silicon, and an intrinsic hydrogenated amorphous carbon silicon oxide film (a-SiOxCy:H) layer can modulate an energy gap to provide excellent passivation performance and provide a hydrogen passivation interface.

### Embodiment 2

A high-efficiency silicon HJT solar cell in this embodiment is basically the same as that in Embodiment 1, except that the high-quality thin SiO₂ layer has a thickness of 3 nm. The hydrogenated amorphous carbon silicon oxide film layer has a thickness of 10 nm. The hydrogenated amorphous carbon silicon oxide film layer has a non-stoichiometric ratio x of 0.95, a non-stoichiometric ratio y of 0.05, and an energy gap of 1.7 eV. The carbon doped SiO₂ layer has a thickness of 5 nm. The amorphous silicon layer that is doped P-type has a thickness of 30 nm, and the amorphous silicon layer that is doped N-type has a thickness of 30 nm. The TCO conductive layer has a thickness of 110 nm.

### Embodiment 3

Referring to FIG. 1, a high-efficiency silicon HJT solar cell in this embodiment includes an N-type crystal silicon wafer 1. A thin SiO₂ layer 301, a hydrogenated amorphous carbon silicon oxide film layer 302, a carbon doped SiO₂ layer 303, an amorphous silicon layer that is doped N-type, a TCO conductive layer 7, and an electrode 9 are sequentially arranged at a front side of the N-type crystal silicon wafer 1. A thin SiO₂ layer 201, a hydrogenated amorphous carbon silicon oxide film layer 202, a carbon doped SiO₂ layer 203, an amorphous silicon layer that is doped P-type, a TCO conductive layer 6, and an electrode 8 are sequentially arranged at a rear side of the N-type crystal silicon wafer 1.

The high-quality thin SiO₂ layer has a thickness of 2 nm, and passivates a surface of a silicon substrate.

The hydrogenated amorphous carbon silicon oxide film layer has a thickness of 5 nm. In this embodiment, the hydrogenated amorphous carbon silicon oxide film layer has a non-stoichiometric ratio x of 0.55, a non-stoichiometric ratio y of 0.45, and an energy gap of 1.95 eV.

The carbon doped SiO₂ layer has a thickness of 3 nm, and a small number of lightly boron doped or lightly phosphorus doped atoms are contained in a manner of doping the SiO₂ layer with the same family, so as to prevent the influence on the passivation effect due to unnecessary doping of the intrinsic hydrogenated amorphous carbon silicon oxide film (a-SiOxCy:H) layer.

The amorphous silicon layer that is doped P-type has a thickness of 20 nm, the amorphous silicon layer that is doped P-type includes a lightly boron doped amorphous silicon layer 401 and a heavily boron doped amorphous silicon layer 402, the lightly boron doped amorphous silicon layer 401 is close to the carbon doped SiO₂ layer 203, and the heavily boron doped amorphous silicon layer 402 is close to the TCO conductive layer 6. By changing a doping source and a doping concentration, the energy gap of the doped layer can be modulated, and a doped layer with high thermal stability and a large energy gap can be formed on a light receiving surface, so that more incident light can pass through the doped layer on the light receiving surface and more light waves can be effectively absorbed to generate photon-generated carriers. In this embodiment, the lightly boron doped amorphous silicon layer 401 is formed by TMB gas doping, and has a thickness of 2 nm and an energy gap of 1.7 eV The heavily boron doped amorphous silicon layer 402 is formed by B₂H₆ gas doping, and has a thickness of 18 nm and an energy gap of 1.4 eV.

The amorphous silicon layer that is doped N-type has a thickness of 20 nm. The amorphous silicon layer that is doped N-type includes a lightly phosphorus doped amorphous silicon layer 501 and a heavily phosphorus doped amorphous silicon layer 502, the lightly phosphorus doped amorphous silicon layer 501 is close to the carbon doped SiO₂ layer 303, and the heavily phosphorus doped amorphous silicon layer 502 is close to the TCO conductive layer 7. The lightly phosphorus doped amorphous silicon layer 501 has a thickness of 2 nm, and the heavily phosphorus doped amorphous silicon layer 502 has a thickness of 18 nm.

The TCO conductive layer has a thickness of 70 nm.

In this embodiment, a small number of lightly boron doped or lightly phosphorus doped atoms diffusing into the intrinsic hydrogenated amorphous carbon silicon oxide film (a-SiOxCy:H) layer are contained in a manner of doping the SiO₂ layer with the same family, so as to prevent unnecessary doping of the intrinsic hydrogenated amorphous carbon silicon oxide film (a-SiOxCy:H) layer and ensure the passivation effect. At the same time, P-type and N-type heavily doped amorphous silicon layers can form good electrical contact with the TCO layer. The P-type amorphous silicon doped layer on a backlight surface is of a dual stacked structure, and TMB gas is used for doping near the carbon doped SiO₂ layer to prevent the diffusion of the doped atoms B (boron) into the intrinsic layer of amorphous silicon, so as to ensure a passivation effect of intrinsic amorphous silicon and increase an open-circuit voltage Voc. The doped amorphous silicon layer close to crystalline silicon is doped with TMB gas, and has a large energy gap, so the light can pass through the doped layer in a higher proportion, thereby increasing absorption of the light by crystalline silicon and increasing a short-circuit current Isc. The doped amorphous silicon layer close to one side of the TCO is heavily doped with B₂H₆ gas. The conductivity of the doped layer is better, and series resistance Rs of the solar cell is lower, so that an FF is higher. Finally, the photoelectric conversion efficiency of the HJT solar cell is improved.

A manufacturing process for a high-efficiency silicon HJT solar cell in this embodiment includes the following steps.

In step one, the N-type crystal silicon wafer 1 is textured and cleaned.

In step two, thin SiO₂ layers are formed on two surfaces of the N-type crystal silicon wafer 1 by thermal oxidation.

In step three, a hydrogenated amorphous carbon silicon oxide film layer is grown, by PECVD, on each of a front surface and a rear surface of the N-type crystal silicon wafer 1 on which the thin SiO₂ layers are formed. In an embodiment, vacuuming to below 5×10⁻⁴ Pa is performed, H₂ and SiH₄ are taken as reaction gases, CO is taken as a carbon source, and an oxygen source is provided to grow the hydrogenated amorphous carbon silicon oxide film layer under conditions that the N-type crystal silicon wafer 1 is at a temperature of 150°C and deposition pressure is 10 Pa. A percentage of a volume of carbon monoxide in a sum of volumes of carbon monoxide and SiH₄ is 5%.

In step four, a carbon doped SiO₂ layer is formed by PECVD, wherein a C source is CO.

In step five, an amorphous silicon layer that is doped N-type and an amorphous silicon layer that is doped P-type are formed by PECVD. The amorphous silicon layer that is doped N-type includes a lightly phosphorus doped amorphous silicon layer (i.e., an N-type amorphous silicon layer lightly doped with P atoms) and a heavily phosphorus doped amorphous silicon layer (i.e., an N-type amorphous silicon layer heavily doped with P atoms), and the amorphous silicon layer that is doped P-type includes a P-type amorphous silicon layer lightly doped with B atoms formed by TMB gas doping and a P-type amorphous silicon layer heavily doped with B atoms formed by B₂H₆ gas doping.

A deposition process of the doped layers involves: after base vacuum of a vacuum chamber reaches 5×10⁻⁴ Pa, growing the amorphous silicon layer that is doped N-type and the amorphous silicon layer that is doped P-type on the hydrogenated amorphous carbon silicon oxide film layer on the rear surface at a temperature of a silicon wafer substrate of 100°C by taking H₂, SiH₄, doped TMB, B₂H₆, and PH₃ as reaction gases, and deposition pressure of 10 Pa.

In step six, a transparent conductive ITO film is deposited at each of the front and rear sides by magnetron sputtering, wherein the film has transmittance above 98% and sheet resistance of 50 Ω/□.

In step seven, another layer of low-temperature conductive silver paste is printed on the TCO conductive layers at the front and rear sides by screen printing, and then sintered at a low temperature of 150°C to form good ohmic contact. An Ag electrode has a thickness of 5 µm, a width of 20 µm, and a spacing of 1 mm.

The HJT solar cell with non-stoichiometric hydrogenated amorphous silicon oxide films as an intrinsic passivation layer and a double diffused boron doped P-type layer has photoelectric conversion efficiency above 24.2%, and the short-circuit current and the open-circuit voltage are increased significantly.

### Embodiment 4

A high-efficiency silicon HJT solar cell in this embodiment is basically the same as that in Embodiment 3, except the following differences.

The amorphous silicon layer that is doped P-type has a thickness of 10 nm, and the lightly boron doped amorphous silicon layer 401 has a thickness of 8 nm and an energy gap of 1.8 eV. The heavily boron doped amorphous silicon layer 402 has a thickness of 2 nm and an energy gap of 1.6 eV.

The amorphous silicon layer that is doped N-type has a thickness of 10 nm, the lightly phosphorus doped amorphous silicon layer 501 has a thickness of 8 nm, and the heavily phosphorus doped amorphous silicon layer 502 has a thickness of 2 nm.

A manufacturing process for a high-efficiency silicon HJT solar cell in this embodiment includes the following steps.

In step one, the N-type crystal silicon wafer 1 is textured and cleaned.

In step two, thin SiO₂ layers are formed on two surfaces of the N-type crystal silicon wafer 1 by thermal oxidation.

In step three, a hydrogenated amorphous carbon silicon oxide film layer is grown, by PECVD, on each of a front surface and a rear surface of the N-type crystal silicon wafer 1 on which the thin SiO₂ layers are formed. In an embodiment, vacuuming to below 5×10⁻⁴ Pa is performed, H₂ and SiH₄ are taken as reaction gases, CO is taken as a carbon source, and an oxygen source is provided to grow the hydrogenated amorphous carbon silicon oxide film layer under conditions that the N-type crystal silicon wafer 1 is at a temperature of 180°C and deposition pressure is 30 Pa. A percentage of a volume of carbon monoxide in a sum of volumes of carbon monoxide and SiH₄ is 5%.

In step four, a carbon doped SiO₂ layer is formed by PECVD, wherein a C source is CO.

In step five, an amorphous silicon layer that is doped N-type and an amorphous silicon layer that is doped P-type are formed by PECVD. A deposition process of the doped layers involves: after base vacuum of a vacuum chamber reaches 5 × 10⁻⁴ Pa, growing the amorphous silicon layer that is doped N-type and the amorphous silicon layer that is doped P-type on the hydrogenated amorphous carbon silicon oxide film layer on the rear surface at a temperature of a silicon wafer substrate of 150°C by taking H₂, SiH₄, doped TMB, B₂H₆, and PH₃ as reaction gases, and deposition pressure of 50 Pa.

In step six, a transparent conductive ITO film is deposited at each of the front and rear sides by magnetron sputtering, wherein the film has a thickness of 80 nm, transmittance above 98% and sheet resistance of 50 Ω/□.

In step seven, another layer of low-temperature conductive silver paste is printed on the TCO conductive layers at the front and rear sides by screen printing, and then sintered at a low temperature of 150°C to form good ohmic contact. An Ag electrode has a thickness of 15 µm, a width of 30 µm, and a spacing of 3 mm.

### Embodiment 5

A high-efficiency silicon HJT solar cell in this embodiment is basically the same as that in Embodiment 3, except the following differences.

The amorphous silicon layer that is doped P-type has a thickness of 30 nm, and the lightly boron doped amorphous silicon layer 401 has a thickness of 18 nm and an energy gap of 1.75 eV The heavily boron doped amorphous silicon layer 402 has a thickness of 12 nm and an energy gap of 1.5 eV.

The amorphous silicon layer that is doped N-type has a thickness of 30 nm, the lightly phosphorus doped amorphous silicon layer 501 has a thickness of 18 nm, and the heavily phosphorus doped amorphous silicon layer 502 has a thickness of 12 nm.

A manufacturing process for a high-efficiency silicon HJT solar cell in this embodiment includes the following steps.

In step one, the N-type crystal silicon wafer 1 is textured and cleaned.

In step two, thin SiO₂ layers are formed on two surfaces of the N-type crystal silicon wafer 1 by thermal oxidation.

In step three, a hydrogenated amorphous carbon silicon oxide film layer is grown, by PECVD, on each of a front surface and a rear surface of the N-type crystal silicon wafer 1 on which the thin SiO₂ layers are formed. In an embodiment, vacuuming to below 5×10⁻⁴ Pa is performed, H₂ and SiH₄ are taken as reaction gases, CO is taken as a carbon source, and an oxygen source is provided to grow the hydrogenated amorphous carbon silicon oxide film layer under conditions that the N-type crystal silicon wafer 1 is at a temperature of 300°C and deposition pressure is 100 Pa. A percentage of a volume of carbon monoxide in a sum of volumes of carbon monoxide and SiH₄ is 30%.

In step four, a carbon doped SiO₂ layer is formed by PECVD, wherein a C source is CO.

In step five, an amorphous silicon layer that is doped N-type and an amorphous silicon layer that is doped P-type are formed by PECVD. A deposition process of the doped layers involves: after base vacuum of a vacuum chamber reaches 5 × 10⁻⁴ Pa, growing the amorphous silicon layer that is doped N-type and the amorphous silicon layer that is doped P-type on the hydrogenated amorphous carbon silicon oxide film layer on the rear surface at a temperature of a silicon wafer substrate of 300°C by taking H₂, SiH₄, doped TMB, B₂H₆, and PH₃ as reaction gases, and deposition pressure of 300 Pa.

In step six, a transparent conductive ITO film is deposited at each of the front and rear sides by reactive ion deposition, wherein the film has a thickness of 110 nm, transmittance above 98% and sheet resistance of 100 Ω/□.

In step seven, another layer of low-temperature conductive silver paste is printed on the TCO conductive layers at the front and rear sides by screen printing, and then sintered at a low temperature of 190°C to form good ohmic contact. An Ag electrode has a thickness of 50 µm, a width of 60 µm, and a spacing of 5 mm.

The present application and implements thereof are illustrated above, but the description is not restrictive. The accompanying drawings are only one of the implementations of the present application, and an actual structure is not limited thereto.

## Claims

1. A high-efficiency silicon heterojunction, HJT, solar cell, comprising:
an N-type crystal silicon wafer (1);
a first thin SiO₂ layer (301), a first intrinsic hydrogenated amorphous carbon silicon oxide film layer (302), a first carbon doped SiO₂ layer (303), a first amorphous silicon layer that is doped N-type (501, 502), a first TCO conductive layer (7), and a first electrode (9) which are sequentially arranged at a front side of the N-type crystal silicon wafer (1), wherein: the first thin SiO₂ layer (301) is arranged between the N-type crystal silicon wafer (1) and the first intrinsic hydrogenated amorphous carbon silicon oxide film layer (302), the first carbon doped SiO₂ layer (303) is arranged between the first intrinsic hydrogenated amorphous carbon silicon oxide film layer (302) and the first amorphous silicon layer (501, 502), and the first TCO conductive layer (7) is arranged between the first amorphous silicon layer (501, 502) and the first electrode (9); and
a second thin SiO₂ layer (201), a second intrinsic hydrogenated amorphous carbon silicon oxide film layer (202), a second carbon doped SiO₂ layer (203), a second amorphous silicon layer that is doped P-type (401, 402), a second TCO conductive layer (6), and a second electrode (8) which are sequentially arranged at a rear side of the N-type crystal silicon wafer (1), wherein: the second thin SiO₂ layer (201) is arranged between the N-type crystal silicon wafer (1) and the second intrinsic hydrogenated amorphous carbon silicon oxide film layer (202), the second carbon doped SiO₂ layer (203) is arranged between the second intrinsic hydrogenated amorphous carbon silicon oxide film layer (202) and the second amorphous silicon layer (401, 402), and the second TCO conductive layer (6) is arranged between the second amorphous silicon layer (401, 402) and the second electrode (8).

2. The high-efficiency silicon HJT solar cell according to claim 1, wherein each of the first and second thin SiO₂ layers has a thickness in a range from 1 nm to 3 nm.

3. The high-efficiency silicon HJT solar cell according to claim 1, wherein each of the first and second intrinsic hydrogenated amorphous carbon silicon oxide film layers has a thickness in a range from 2 nm to 10 nm and an energy gap in a range from 1.7 eV to 2.3 eV

4. The high-efficiency silicon HJT solar cell according to claim 3, wherein each of the first and second intrinsic hydrogenated amorphous carbon silicon oxide film layers is non-stoichiometric and has a chemical formula expressed as a-SiOxCy:H, with a non-stoichiometric ratio x changing in a range from 0.05 to 0.95 and a non-stoichiometric ratio y changing in a range from 0.05 to 0.95.

5. The high-efficiency silicon HJT solar cell according to claim 4, wherein each of the first and second carbon doped SiO₂ layers has a thickness in a range from 1 nm to 5 nm.

6. The high-efficiency silicon HJT solar cell according to any one of claims 1 to 5, wherein the second amorphous silicon layer has a thickness in a range from 10 nm to 30 nm; the second amorphous silicon layer comprises a lightly boron doped amorphous silicon layer (401) and a heavily boron doped amorphous silicon layer (402), the lightly boron doped amorphous silicon layer (401) is close to the second carbon doped SiO₂ layer (203), and the heavily boron doped amorphous silicon layer (402) is close to the second TCO conductive layer (6).

7. The high-efficiency silicon HJT solar cell according to claim 6, wherein the lightly boron doped amorphous silicon layer (401) is formed by TMB gas doping, and has a thickness in a range from 2 nm to 20 nm and an energy gap in a range from 1.7 eV to 1.8 eV.

8. The high-efficiency silicon HJT solar cell according to claim 7, wherein the heavily boron doped amorphous silicon layer (402) is formed by B₂H₆ gas doping, and has a thickness in a range from 2 nm to 20 nm and an energy gap in a range from 1.4 eV to 1.6 eV

9. The high-efficiency silicon HJT solar cell according to any one of claims 1 to 5, wherein the first amorphous silicon layer has a thickness in a range from 10 nm to 30 nm; the first amorphous silicon layer comprises a lightly phosphorus doped amorphous silicon layer (501) and a heavily phosphorus doped amorphous silicon layer (502), the lightly phosphorus doped amorphous silicon layer (501) is close to the first carbon doped SiO₂ layer (303), and the heavily phosphorus doped amorphous silicon layer (502) is close to the first TCO conductive layer (7); the lightly phosphorus doped amorphous silicon layer (501) has a thickness in a range from 2 nm to 20 nm, and the heavily phosphorus doped amorphous silicon layer (502) has a thickness in a range from 2 nm to 20 nm.

10. The high-efficiency silicon HJT solar cell according to claim 8, wherein the first amorphous silicon layer has a thickness in a range from 10 nm to 30 nm; the first amorphous silicon layer comprises a lightly phosphorus doped amorphous silicon layer (501) and a heavily phosphorus doped amorphous silicon layer (502), the lightly phosphorus doped amorphous silicon layer (501) is close to the first carbon doped SiO₂ layer (303), and the heavily phosphorus doped amorphous silicon layer (502) is close to the first TCO conductive layer (7); the lightly phosphorus doped amorphous silicon layer (501) has a thickness in a range from 2 nm to 20 nm, and the heavily phosphorus doped amorphous silicon layer (502) has a thickness in a range from 2 nm to 20 nm.

11. A manufacturing method for the high-efficiency silicon HJT solar cell according to any one of claims 1 to 10, the method comprising:
texturing and cleaning the N-type crystal silicon wafer (1);
forming the first and second thin SiO₂ layers on two surfaces of the N-type crystal silicon wafer (1) by thermal oxidation;
growing, by plasma enhanced chemical vapor deposition, PECVD, the first and second intrinsic hydrogenated amorphous carbon silicon oxide film layers respectively on a front surface and a rear surface of the N-type crystal silicon wafer (1) on which the thin SiO₂ layers are formed;
forming the first and second carbon doped SiO₂ layers by PECVD;
forming the first amorphous silicon layer and the second amorphous silicon layer by PECVD;
depositing the first and second TCO conductive layers by reactive ion deposition or sputtering; and
forming the first and second electrodes by screen printing.

12. The manufacturing method for the high-efficiency silicon HJT solar cell according to claim 11, wherein the growing, by PECVD, the first and second intrinsic hydrogenated amorphous carbon silicon oxide film layers comprises:
vacuuming to below 5×10⁻⁴ Pa, taking H₂ and SiH₄ as reaction gases and CO as a carbon source, and providing an oxygen source to grow the first and second intrinsic hydrogenated amorphous carbon silicon oxide film layers under conditions that the N-type crystal silicon wafer (1) is at a temperature in a range from 150°C to 300°C and deposition pressure is in a range from 10 Pa to 100 Pa, wherein a percentage of a volume of carbon monoxide in a sum of volumes of carbon monoxide and SiH₄ is between 5% and 30%.

13. The manufacturing method for the high-efficiency silicon HJT solar cell according to claim 12, wherein the forming the first amorphous silicon layer and the second amorphous silicon layer by PECVD comprises:
after base vacuum of a vacuum chamber reaches 5×10⁻⁴ Pa, growing the first amorphous silicon layer and the second amorphous silicon layer on the intrinsic hydrogenated amorphous carbon silicon oxide film layer on the rear surface at a temperature of a silicon wafer substrate in a range from 100°C to 300°C by taking H₂, SiH₄, doped TMB, B₂H₆, and PH₃ as reaction gases, and deposition pressure in a range from 10 Pa to 300 Pa.

14. The manufacturing method for the high-efficiency silicon HJT solar cell according to claim 13, wherein the depositing the first and second TCO conductive layers by reactive ion deposition or sputtering comprises:
depositing a transparent conductive ITO film on each of the front and rear surfaces by magnetron sputtering, the film having a thickness in a range from 70 nm to 110 nm, transmittance above 98%, and sheet resistance in a range from 50Ω/□to 100 Ω/□.

15. The manufacturing method for the high-efficiency silicon HJT solar cell according to claim 14, wherein the forming the first and second electrodes by screen printing comprises:
printing another layer of low-temperature conductive silver paste on the TCO conductive layers on the front and rear surfaces by screen printing, and then sintering the low-temperature conductive silver paste at a low temperature in a range from 150°C to 300°C to form good ohmic contact; an Ag electrode having a thickness in a range from 5 µm to 50 µm, a width in a range from 20 µm to 60 µm, and a spacing in a range from 1 mm to 5 mm.

## Patentansprüche

1. Hocheffiziente Silizium-Heteroübergangs-, HJT, Solarzelle, umfassend:
einen N-Kristallsiliziumwafer (1);
eine erste dünne SiO₂-Schicht (301), eine erste intrinsische, hydrierte, amorphe Kohlenstoff-Siliziumoxid-Filmschicht (302), eine erste kohlenstoffdotierte SiO₂-Schicht (303), eine erste amorphe, N-dotierte Siliziumschicht (501, 502), eine erste leitfähige TCO-Schicht (7) und eine erste Elektrode (9), die nacheinander auf einer Vorderseite des N-dotierten Siliziumwafers (1) angeordnet sind, wobei: die erste dünne SiO₂-Schicht (301) zwischen dem N-Kristallsiliziumwafer (1) und der ersten intrinsischen, hydrierten, amorphen Kohlenstoff-Siliziumoxid-Filmschicht (302) angeordnet ist, die erste kohlenstoffdotierte SiO₂-Schicht (303) zwischen der ersten intrinsischen, hydrierten, amorphen Kohlenstoff-Siliziumoxid-Filmschicht (302) und der ersten amorphen Siliziumschicht (501, 502) angeordnet ist und die erste leitfähige TCO-Schicht (7) zwischen der ersten amorphen Siliziumschicht (501, 502) und der ersten Elektrode (9) angeordnet ist; und
eine zweite dünne SiO₂-Schicht (201), eine zweite intrinsische, hydrierte, amorphe Kohlenstoff-Siliziumoxid-Filmschicht (202), eine zweite kohlenstoffdotierte SiO₂-Schicht (203), eine zweite amorphe, P-dotierte Siliziumschicht (401, 402), eine zweite leitfähige TCO-Schicht (6) und eine zweite Elektrode (8), die nacheinander auf einer Rückseite des N-dotierten Siliziumwafers (1) angeordnet sind, wobei: die zweite dünne SiO₂-Schicht (201) zwischen dem N-Kristallsiliziumwafer (1) und der zweiten intrinsischen, hydrierten, amorphen Kohlenstoff-Siliziumoxid-Filmschicht (202) angeordnet ist, die zweite kohlenstoffdotierte SiO₂-Schicht (203) zwischen der zweiten intrinsischen, hydrierten, amorphen Kohlenstoff-Siliziumoxid-Filmschicht (202) und der zweiten amorphen Siliziumschicht (401, 402) angeordnet ist und die zweite leitfähige TCO-Schicht (6) zwischen der zweiten amorphen Siliziumschicht (401, 402) und der zweiten Elektrode (8) angeordnet ist.

2. Hocheffiziente Silizium-HJT-Solarzelle nach Anspruch 1, wobei jede der ersten und der zweiten dünnen SiO₂-Schicht eine Dicke in einem Bereich von 1 nm bis 3 nm aufweist.

3. Hocheffiziente Silizium-HJT-Solarzelle nach Anspruch 1, wobei jede der ersten und der zweiten intrinsischen, hydrierten, amorphen Kohlenstoff-Siliziumoxid-Filmschicht eine Dicke in einem Bereich von 2 nm bis 10 nm und eine Bandlücke in einem Bereich von 1,7 eV bis 2,3 eV aufweist.

4. Hocheffiziente Silizium-HJT-Solarzelle nach Anspruch 3, wobei jede der ersten und der zweiten intrinsischen, hydrierten, amorphen Kohlenstoff-Siliziumoxid-Filmschicht nicht-stöchiometrisch ist und eine mit a-SiOxCy:H ausgedrückte chemische Formel aufweist, mit einem nichtstöchiometrischen Verhältnis x, das sich in einem Bereich von 0,05 bis 0,95 ändert, und einem nichtstöchiometrischen Verhältnis y, das sich in einem Bereich von 0,05 bis 0,95 ändert.

5. Hocheffiziente Silizium-HJT-Solarzelle nach Anspruch 4, wobei jede der ersten und der zweiten kohlenstoffdotierten SiO₂-Schicht eine Dicke in einem Bereich von 1 nm bis 5 nm aufweist.

6. Hocheffiziente Silizium-HJT-Solarzelle nach einem der Ansprüche 1 bis 5, wobei die zweite amorphe Siliziumschicht eine Dicke in einem Bereich von 10 nm bis 30 nm aufweist; die zweite amorphe Siliziumschicht eine schwach bordotierte amorphe Siliziumschicht (401) und eine stark bordotierte amorphe Siliziumschicht (402) umfasst, wobei die schwach bordotierte amorphe Siliziumschicht (401) nahe an der zweiten kohlenstoffdotierten SiO₂-Schicht (203) liegt und die stark bordotierte amorphe Siliziumschicht (402) nahe an der zweiten leitfähigen TCO-Schicht (6) liegt.

7. Hocheffiziente Silizium-HJT-Solarzelle nach Anspruch 6, wobei die schwach bordotierte amorphe Siliziumschicht (401) durch TMB-Gasdotierung gebildet wird und eine Dicke in einem Bereich von 2 nm bis 20 nm und eine Bandlücke in einem Bereich von 1,7 eV bis 1,8 eV aufweist.

8. Hocheffiziente Silizium-HJT-Solarzelle nach Anspruch 7, wobei die stark bordotierte amorphe Siliziumschicht (402) durch B₂H₆-Gasdotierung gebildet wird und eine Dicke in einem Bereich von 2 nm bis 20 nm sowie eine Bandlücke in einem Bereich von 1,4 eV bis 1,6 eV aufweist.

9. Hocheffiziente Silizium-HJT-Solarzelle nach einem der Ansprüche 1 bis 5, wobei die erste amorphe Siliziumschicht eine Dicke in einem Bereich von 10 nm bis 30 nm aufweist; die erste amorphe Siliziumschicht eine schwach phosphordotierte amorphe Siliziumschicht (501) und eine stark phosphordotierte amorphe Siliziumschicht (502) umfasst, wobei die schwach phosphordotierte amorphe Siliziumschicht (501) nahe an der ersten kohlenstoffdotierten SiO₂-Schicht (303) liegt und die stark phosphordotierte amorphe Siliziumschicht (502) nahe an der ersten leitfähigen TCO-Schicht (7) liegt; die schwach phosphordotierte amorphe Siliziumschicht (501) eine Dicke in einem Bereich von 2 nm bis 20 nm aufweist und die stark phosphordotierte amorphe Siliziumschicht (502) eine Dicke in einem Bereich von 2 nm bis 20 nm aufweist.

10. Hocheffiziente Silizium-HJT-Solarzelle nach Anspruch 8, wobei die erste amorphe Siliziumschicht eine Dicke in einem Bereich von 10 nm bis 30 nm aufweist; die erste amorphe Siliziumschicht eine schwach phosphordotierte amorphe Siliziumschicht (501) und eine stark phosphordotierte amorphe Siliziumschicht (502) umfasst, wobei die schwach phosphordotierte amorphe Siliziumschicht (501) nahe an der ersten kohlenstoffdotierten SiO₂-Schicht (303) liegt und die stark phosphordotierte amorphe Siliziumschicht (502) nahe an der ersten leitfähigen TCO-Schicht (7) liegt; die schwach phosphordotierte amorphe Siliziumschicht (501) eine Dicke in einem Bereich von 2 nm bis 20 nm aufweist und die stark phosphordotierte amorphe Siliziumschicht (502) eine Dicke in einem Bereich von 2 nm bis 20 nm aufweist.

11. Herstellungsverfahren für die hocheffiziente Silizium-HJT-Solarzelle nach einem der Ansprüche 1 bis 10, wobei das Verfahren Folgendes umfasst:
Texturieren und Reinigen des N-Kristallsiliziumwafers (1);
Bilden der ersten und der zweiten dünnen SiO₂-Schicht auf zwei Oberflächen des N-Kristallsiliziumwafers (1) durch thermische Oxidation;
Aufwachsen, durch plasmaverstärkte chemische Gasphasenabscheidung, PECVD, der ersten und der zweiten intrinsischen, hydrierten, amorphen Kohlenstoff-Siliziumoxid-Filmschicht auf einer Vorderfläche bzw. Rückfläche des N-Kristallsiliziumwafers (1), auf dem die dünnen SiO₂-Schichten gebildet werden;
Bilden der ersten und der zweiten kohlenstoffdotierten SiO₂-Schicht mittels PECVD;
Bilden der ersten amorphen Siliziumschicht und der zweiten amorphen Siliziumschicht mittels PECVD;
Abscheiden der ersten und der zweiten leitfähigen TCO-Schicht mittels reaktiver Ionenabscheidung oder Sputtern; und
Bilden der ersten und der zweiten Elektrode mittels Siebdruck.

12. Herstellungsverfahren für die hocheffiziente Silizium-HJT-Solarzelle nach Anspruch 11, wobei das Aufwachsen, mittels PECVD, der ersten und der zweiten intrinsischen, hydrierten, amorphen Kohlenstoff-Siliziumoxid-Filmschicht Folgendes umfasst:
Vakuumieren auf unter 5 x10⁻⁴ Pa, Verwenden von H₂ und SiH₄ als Reaktionsgase und CO als eine Kohlenstoffquelle und Bereitstellen von Sauerstoff zur Herstellung der ersten und zweiten intrinsischen, hydrierten, amorphen Kohlenstoff-Siliziumoxid-Schichten unter Bedingungen, bei denen sich der N-Kristallsiliziumwafer (1) bei einer Temperatur in einem Bereich von 150 °C bis 300 °C befindet und ein Abscheidungsdruck in einem Bereich von 10 Pa bis 100 Pa liegt, wobei ein Prozentsatz eines Volumens von Kohlenmonoxid in einer Summe von Volumina von Kohlenmonoxid und SiH₄ zwischen 5% und 30% liegt.

13. Herstellungsverfahren für die hocheffiziente Silizium-HJT-Solarzelle nach Anspruch 12, wobei das Bilden der ersten amorphen Siliziumschicht und der zweiten amorphen Siliziumschicht mittels PECVD Folgendes umfasst:
nachdem ein Basisvakuum einer Vakuumkammer 5x10⁻⁴ Pa erreicht hat, Aufwachsen der ersten amorphen Siliziumschicht und der zweiten amorphen Siliziumschicht auf der intrinsischen, hydrierten, amorphen Kohlenstoff-Siliziumoxid-Schicht auf der Rückfläche bei einer Temperatur eines Siliziumwafer-Substrats von 100°C bis 300°C unter Verwendung von H₂, SiH₄, dotiertem TMB, B₂H₆ und PH₃ als Reaktionsgase und einem Abscheidungsdruck in einem Bereich von 10 Pa bis 300 Pa.

14. Herstellungsverfahren für die hocheffiziente Silizium-HJT-Solarzelle nach Anspruch 13, wobei das Abscheiden der ersten und der zweiten leitfähigen TCO-Schicht durch reaktive Ionenabscheidung oder Sputtern Folgendes umfasst:
Abscheiden eines transparenten leitfähigen ITO-Films sowohl auf der Vorder- als auch der Rückfläche mittels Magnetron-Sputtern, wobei der Film eine Dicke in einem von 70 nm bis 110 nm, einen Durchlassgrad über 98%, und einen Flächenwiderstand in einem Bereich von 50 Ω/□ bis 100 Ω/□ aufweist.

15. Herstellungsverfahren für die hocheffiziente Silizium-HJT-Solarzelle nach Anspruch 14, wobei das Bilden der ersten und der zweiten Elektrode mittels Siebdruck Folgendes umfasst:
Drucken einer weiteren Schicht aus niedrigtemperaturleitfähiger Silberpaste auf den leitfähigen TCO-Schichten an der Vorder- und der Rückfläche mittels Siebdruck, und dann Sintern der niedrigtemperaturleitfähigen Silberpaste bei einer niedrigen Temperatur in einem Bereich von 150°C bis 300°C, um einen guten ohmschen Kontakt zu bilden; wobei die Ag-Elektrode eine Dicke in einem Bereich von 5 µm bis 50 µm, eine Breite in einem Bereich von 20 µm bis 60 µm und einen Abstand in einem Bereich von 1 mm bis 5 mm aufweist.

## Revendications

1. Cellule solaire à hétérojonction de silicium à haut rendement, HJT, comprenant :
une plaquette de silicium cristallin de type N (1) ;
une première couche de SiO₂ mince (301), une première couche de film d'oxyde de silicium de carbone amorphe hydrogéné intrinsèque (302), une première couche de SiO₂ dopée au carbone (303), une première couche de silicium amorphe dopée de type N (501, 502), une première couche conductrice TCO (7) et une première électrode (9) qui sont agencées séquentiellement sur un côté avant d'une plaquette de silicium cristallin de type N (1), dans laquelle : la première couche de SiO₂ mince (301) est agencée entre la plaquette de silicium cristallin de type N (1) et la première couche de film d'oxyde de silicium de carbone amorphe hydrogéné intrinsèque (302), la première couche de SiO₂ dopée au carbone (303) est agencée entre la première couche de film d'oxyde de silicium de carbone amorphe hydrogéné intrinsèque (302) et la première couche de silicium amorphe (501, 502), et la première couche conductrice TCO (7) est agencée entre la première couche de silicium amorphe (501, 502) et la première électrode (9) ; et
une seconde couche de SiO₂ mince (201), une seconde couche de film d'oxyde de silicium de carbone amorphe hydrogéné intrinsèque (202), une seconde couche de SiO₂ dopée au carbone (203), une seconde couche de silicium amorphe dopée de type P (401, 402), une seconde couche conductrice TCO (6) et une seconde électrode (8) qui sont agencées séquentiellement sur un côté arrière d'une plaquette de silicium cristallin de type N (1), dans laquelle : la seconde couche de SiO₂ mince (201) est agencée entre la plaquette de silicium cristallin de type N (1) et la seconde couche de film d'oxyde de silicium de carbone amorphe hydrogéné intrinsèque (202), la seconde couche de SiO₂ dopée au carbone (203) est agencée entre la seconde couche de film d'oxyde de silicium de carbone amorphe hydrogéné intrinsèque (202) et la seconde couche de silicium amorphe (401, 402), et la seconde couche conductrice TCO (6) est agencée entre la seconde couche de silicium amorphe (401, 402) et la seconde électrode (8).

2. Cellule solaire HJT de silicium à haut rendement selon la revendication 1, dans laquelle chacune des première et seconde couches de SiO₂ minces présente une épaisseur dans une plage de 1 nm à 3 nm.

3. Cellule solaire HJT de silicium à haut rendement selon la revendication 1, dans laquelle chacune des première et seconde couches de film d'oxyde de silicium de carbone amorphe hydrogéné intrinsèque présente une épaisseur dans une plage de 2 nm à 10 nm et une largeur de bande interdite dans une plage de 1,7 eV à 2,3 eV.

4. Cellule solaire HJT de silicium à haut rendement selon la revendication 3, dans laquelle chacune des première et seconde couches de film d'oxyde de silicium amorphe hydrogéné intrinsèque est non stœchiométrique et présente une formule chimique exprimée en tant que a-SiOxCy:H, avec un rapport non stœchiométrique x changeant dans une plage de 0,05 à 0,95 et un rapport non stœchiométrique y changeant dans une plage de 0,05 à 0,95.

5. Cellule solaire HJT de silicium à haut rendement selon la revendication 4, dans laquelle chacune des première et seconde couches de SiO₂ dopées au carbone présente une épaisseur dans une plage de 1 nm à 5 nm.

6. Cellule solaire HJT de silicium à haut rendement selon l'une quelconque des revendications 1 à 5, dans laquelle la seconde couche de silicium amorphe présente une épaisseur dans une plage de 10 nm à 30 nm ; la seconde couche de silicium amorphe comprend une couche de silicium amorphe légèrement dopée au bore (401) et une couche de silicium amorphe fortement dopée au bore (402), la couche de silicium amorphe légèrement dopée au bore (401) est proche de la seconde couche de SiO₂ dopée au carbone (203), et la couche de silicium amorphe fortement dopée au bore (402) est proche de la seconde couche conductrice TCO (6).

7. Cellule solaire HJT de silicium à haut rendement selon la revendication 6, dans laquelle la couche de silicium amorphe légèrement dopée au bore (401) est formée par dopage au gaz TMB et présente une épaisseur dans une plage de 2 nm à 20 nm et une largeur de bande interdite dans une plage de 1,7 eV à 1,8 eV.

8. Cellule solaire HJT de silicium à haut rendement selon la revendication 7, dans laquelle la couche de silicium amorphe fortement dopée au bore (402) est formée par dopage au gaz B₂H₆ et présente une épaisseur dans une plage de 2 nm à 20 nm et une largeur de bande interdite dans une plage de 1,4 eV à 1,6 eV.

9. Cellule solaire HJT de silicium à haut rendement selon l'une quelconque des revendications 1 à 5, dans laquelle la première couche de silicium amorphe présente une épaisseur dans une plage de 10 nm à 30 nm ; la première couche de silicium amorphe comprend une couche de silicium amorphe légèrement dopée au phosphore (501) et une couche de silicium amorphe fortement dopée au phosphore (502), la couche de silicium amorphe légèrement dopée au phosphore (501) est proche de la première couche de SiO₂ dopée au carbone (303), et la couche de silicium amorphe fortement dopée au phosphore (502) est proche de la première couche conductrice TCO (7) ; la couche de silicium amorphe légèrement dopée au phosphore (501) présente une épaisseur dans une plage de 2 nm à 20 nm, et la couche de silicium amorphe fortement dopée au phosphore (502) présente une épaisseur dans une plage de 2 nm à 20 nm.

10. Cellule solaire HJT de silicium à haut rendement selon la revendication 8, dans laquelle la première couche de silicium amorphe présente une épaisseur dans une plage de 10 nm à 30 nm ; la première couche de silicium amorphe comprend une couche de silicium amorphe légèrement dopée au phosphore (501) et une couche de silicium amorphe fortement dopée au phosphore (502), la couche de silicium amorphe légèrement dopée au phosphore (501) est proche de la première couche de SiO₂ dopée au carbone (303), et la couche de silicium amorphe fortement dopée au phosphore (502) est proche de la première couche conductrice TCO (7) ; la couche de silicium amorphe légèrement dopée au phosphore (501) présente une épaisseur dans une plage de 2 nm à 20 nm, et la couche de silicium amorphe fortement dopée au phosphore (502) présente une épaisseur dans une plage de 2 nm à 20 nm.

11. Procédé de fabrication de la cellule solaire HJT de silicium à haut rendement selon l'une quelconque des revendications 1 à 10, le procédé comprenant :
la texturation et le nettoyage de la plaquette de silicium cristallin de type N (1) ;
la formation des première et seconde couches de SiO₂ minces sur deux surfaces de la plaquette de silicium cristallin de type N (1) par oxydation thermique ;
la croissance, par dépôt en phase vapeur chimique assisté par plasma, PECVD, des première et seconde couches de film d'oxyde de silicium amorphe de carbone hydrogéné intrinsèque respectivement sur une surface avant et une surface arrière de la plaquette de silicium cristallin de type N (1) sur laquelle les couches de SiO₂ minces sont formées ;
la formation des première et seconde couches de SiO₂ dopées au carbone par PECVD ;
la formation de la première couche de silicium amorphe et de la seconde couche de silicium amorphe par PECVD ;
le dépôt des première et seconde couches conductrices TCO par dépôt ionique réactif ou pulvérisation ; et
la formation des première et seconde électrodes par sérigraphie.

12. Procédé de fabrication de la cellule solaire HJT de silicium à haut rendement selon la revendication 11, dans lequel la croissance, par PECVD, des première et seconde couches de film d'oxyde de silicium de carbone amorphe hydrogéné intrinsèque comprend :
la mise sous vide à moins de 5 x10⁻⁴ Pa, en prenant H₂ et SiH₄ comme gaz de réaction et CO comme source de carbone, et la fourniture d'une source d'oxygène pour la croissance des première et seconde couches de film d'oxyde de silicium de carbone amorphe hydrogéné intrinsèque dans des conditions telles que la plaquette de silicium cristallin de type N (1) est à une température dans une plage de 150 °C à 300 °C et la pression de dépôt est dans une plage de 10 Pa à 100 Pa, dans lequel un pourcentage d'un volume de monoxyde de carbone par rapport à une somme de volumes de monoxyde de carbone et de SiH₄ est entre 5 % et 30 %.

13. Procédé de fabrication de la cellule solaire HJT de silicium à haut rendement selon la revendication 12, dans lequel la formation de la première couche de silicium amorphe et de la seconde couche de silicium amorphe par PECVD comprend :
après que le vide de base d'une chambre à vide atteint 5x10⁻⁴ Pa, la croissance de la première couche de silicium amorphe et la seconde couche de silicium amorphe sur la couche de film d'oxyde de silicium de carbone amorphe hydrogéné intrinsèque sur la surface arrière à une température d'un substrat de plaquette de silicium dans une plage de 100 °C à 300 °C en prenant H₂, SiH₄, TMB dopé, B₂H₆ et PH₃ comme gaz de réaction, et une pression de dépôt dans une plage de 10 Pa à 300 Pa.

14. Procédé de fabrication de la cellule solaire HJT de silicium à haut rendement selon la revendication 13, dans lequel le dépôt des première et seconde couches conductrices TCO par dépôt ionique réactif ou pulvérisation comprend :
le dépôt d'un film ITO conducteur transparent sur chacune des surfaces avant et arrière par pulvérisation magnétron, le film présentant une épaisseur dans une plage de 70 nm à 110 nm, une transmittance supérieure à 98 % et une résistance de couche dans une plage de 50 Ω/□ à 100 Ω/□.

15. Procédé de fabrication de la cellule solaire HJT de silicium à haut rendement selon la revendication 14, dans lequel la formation des première et seconde électrodes par sérigraphie comprend :
l'impression d'une autre couche de pâte d'argent conductrice à basse température sur les couches conductrices TCO des surfaces avant et arrière par sérigraphie, puis frittage de la pâte d'argent conductrice à basse température à une température basse dans une plage de 150 °C à 300 °C pour former un bon contact ohmique ; une électrode Ag présentant une épaisseur dans une plage de 5 µm à 50 µm, une largeur dans une plage de 20 µm à 60 µm et un espacement dans une plage de 1 mm à 5 mm.
